# EUROPEAN PATENT SPECIFICATION

(11) **EP 3 449 510 B1**
(45) Date of publication and mention of the grant of the patent: **08.11.2023**
(21) Application number: 17718101.3
(22) Date of filing: 21.04.2017
(51) Int. Cl.: H01L 31/05

(54) **ASSEMBLY**
ANORDNUNG
ENSEMBLE

(30) Priority: 29.04.2016 EP 16167614
(43) Date of publication of application: 06.03.2019
(73) Proprietor: AGC Glass Europe, 1348 Louvain-La-Neuve (BE); AGC Inc., Tokyo 100-8405 (JP); AGC Glass Company North America, Alpharetta, GA 30022-1167 (US)
(72) Inventor: POOT, Benoît, 7850 Petit-Enghien (BE); DEMEYERE, Michaël, 5380 Forville (BE)
(74) Representative: AGC Glass Europe
(86) International application number: PCT/EP2017/059544
(87) International publication number: WO 2017/186592

(56) References cited:
- WO-A1-2012/052542
- DE-A1-102010 018 548
- DE-U1-202007 017 775
- US-A1- 2005 241 692
- US-A1- 2008 000 195
- US-A1- 2015 034 147
- US-A1- 2015 059 835

## Description

### Technical Domain of the Invention

The field of the present invention relates to buildings or land vehicles for housing people or transporting people, or any other element such as street furniture, noise barriers, greenhouses, balustrades, louvers or double skin glasses, which comprise glazing panels with assembly comprising functional films and to the process for obtaining the assembly.

### Background of the Invention

Functional films are known as specific films able to add properties to the assembly such as lighting, photovoltaic, privacy,... They can be assembled alone or in arrays. It means that in an assembly, it is possible to find only one or a plurality of functional films.

Some functional films need to be connected to a power supply, battery to receive the energy to work correctly or to a system able to retrieve the energy generated for example, this is the case of the photovoltaic modules.

Photovoltaic (PV) modules and cells based on inorganic wafers are well known. PV modules based on thin film modules, rather than on wafers have also been developed.

On the other hand, organic photovoltaic modules and cells have been published. Usually organic photovoltaic devices comprise at least two electrodes and at least one photoactive layer and optionally various other doped and/or un-doped layers between the electrodes. The other layers have different functions, for instance carrier transport, blocking or passivation layers. The photoactive layers of some published photoactive components comprise layers with small molecules. These photoactive layers are often formed as mixed layers for getting highly efficient devices. In the context of the present invention, small molecules are understood to be non-polymeric organic molecules having monodisperse molar masses of between 100 and 2000. In particular, these small molecules can also be photoactive, wherein photoactive is understood to mean that the molecules change their charge state under light incidence (WO 2004/083958 A2, WO 2006/092134 A1, WO 2011/161108 A1) where the quantum efficiency of the charge transfer process is enhanced by electric fields and appropriate heterojunctions between donor-type and acceptor-type molecules.

To connect functional films together or to the outside of the assembly, it is known to use conductive means such as cable, wire or busbar depending on the technology needed.

It is also known to facilitate the outside connection to pass through a junction box. A junction box may be placed on the edge or on the surface of the assembly. To connect to the junction box, two connections are needed, one for the positive pole and another one for the negative pole.

Several functional films can be connected together in an assembly. They can be connected in parallel or in series. For crystalline silicon, they are usually connected in series but the situation could be different for other PV technologies since the voltage or current properties are different and since the total voltage of the circuit composed by the films can increase rapidly for example. Thus, there can be an interest to connect the cells in parallel. To connect in parallel several functional films to a junction box, one of the conductive means has to pass around the functional film placed at the nearest place of the junction box to be connected to the corresponding busbar.

This kind of assembly leads to long conductive means that are generally difficult to handle. Furthermore, in this kind of assembly conductive means can move during the assembling process leading to aesthetic defects of the product such as banana-shape effect. It also increases the cost of production because the assembly process is more complex and because the banana-shaped strips can lead to out-of-specification product.

Document US 2015/0059835 A1 discloses an assembly comprising a transparent substrate and an array of functional films having two busbars along their borders.

### Summary of the Invention

The invention relates to an improved assembly comprising a plurality of functional films according to claim 1. The invention relates also to an improved method of connecting several functional films together in a such assembly according to claim 7.

Thus, the invention relates to an assembly comprising a transparent substrate; a junction box; at least one array arranged on the transparent substrate comprising a plurality of functional films with a first and a last functional film, the first functional film being placed at the nearest place from the junction box.

According to the present invention, each functional film is composed of an active element and two busbars able to electrically connect the active element. The two busbars are oppositely disposed along at least a part of the border of the active element. According to the present invention, functional films are electrically connected in parallel starting from the first functional film; conductive means linking functional films together and linking directly the first functional film to the junction box. According to the present invention, one of the two busbars of the first functional film is connected to two conductive means and the other busbar is connected to a third conductive mean.

In that manner, the current is carried through the busbar of the functional film instead of a conductive means turning around the functional film.

According to the present invention, the expression "the functional film being placed at nearest place from the junction box" should be understood as 'the functional film of the array placed at the shortest distance from the junction box corresponding of this array".

According to the present invention, the expression "the first functional film is directly linked to the junction box" should be understood as "the first functional film is physically connected to the junction box by conductive means".

More particularly, one of the two busbars of the first functional film is directly connected to the junction box via one of the two conductive means and directly connected to others functional films via the other conductive mean. The other busbar of the first functional film is directly connected to the junction box and to others functional films via the third conductive mean.

According to the present invention, the transparent substrate can be a flat or curved panel to fit with the design of the assembly. Also, the transparent substrate can be clear or mass-colored or tinted with a specific composition or by applying a coating or a plastic layer for example. The transparent substrate can be a transparent layered structure for safety reasons.

According to the invention, the transparent substrate is preferably a glass sheet. The glass sheet can be tempered with respect to the specifications of safety. The glass sheet can also be a laminated glass structure. Preferably, the glass sheet has a high energy transmission (ET).

The glass sheet according to the invention has preferably an energy transmission (ET), for a thickness of 3.85 mm, of at least 89%. Advantageously, the glass sheet according to the invention has an energy transmission (ET), for a thickness of 3.85 mm, of at least 90%, and more preferably at least 91%.

According to one embodiment of the invention, the glass sheet is advantageously made of a glass with low iron content. By glass low iron content, is meant a glass having a composition comprising a total iron content (expressed in terms of Fe2O3) less than 0.06% by weight relative to the total weight of the glass. Iron is an absorbent element, this maximum value of iron content helps limit losses due to the absorption of radiation as it passes through the glass and thus, increase the energy transmission of the glass sheet. Preferably, the glass sheet is made of a glass whose composition comprises a total iron content (expressed as Fe2O3) from 0.002 to 0.04% by weight relative to the total weight of the glass. In any preferred manner, the glass sheet is made of a glass whose composition comprises a total iron content (expressed as Fe2O3) from 0.002 to 0.02% by weight relative to the total weight of the glass. A total iron content (expressed as Fe2O3) less than or equal to 0.02% by weight increases more energy transmission of the glass sheet. The minimum value allows not excessively penalizing the cost of the glass because such low iron values often require very pure raw materials or expensive purification thereof.

According to the invention, conductive means are preferably conductive strips. These conductive strips are chosen in order to limit the electrical losses. This could be done by a combination of materials and section (combination of thickness and width). Conductive means are preferably flat conductive elements. Conductive strips are preferably made with metal based material and more preferably copper (Cu)-based material.

Functional films are photovoltaic films. The term "photovoltaic films" denotes any component having a semiconductive, photoactive functional layer and a bottom electrode made of organic or inorganic material; a semiconductive, photovoltaically active functional layer; and a top conductive functional layer (electrode) made of predominantly organic material.

More preferably, functional films are organic photovoltaic films. The term "organic" herein encompasses all types of organic, metalorganic and/or inorganic synthetic materials. This includes all types of materials except for semiconductors used for conventional diodes (germanium, silicon) and typical metallic conductors. Thus, no limitation is intended in the dogmatic sense to organic material as carbon-containing material, but rather, the widespread use of, for example, silicones is also contemplated. Furthermore, the term is not intended to imply any limitation with respect to molecular size, particularly to polymeric and/or oligomeric materials, but rather, the use of "small molecules" is also by all means possible.

Thus, the invention relates to a process to manufacture an assembly comprising a transparent substrate; a junction box; at least one array arranged on the transparent substrate comprising a plurality of functional films with a first and a last functional film, the first functional film being placed at the nearest place from the junction box.

According to the present invention, each functional film is composed of an active element and two busbars able to electrically connect the active element. The two busbars are oppositely disposed along at least a part of the border of the active element.

According to the present invention, functional films are electrically connected in parallel starting from the first functional film; conductive means linking functional films together and linking directly the first functional film to the junction box, comprising the following steps:
- applying the functional films on the transparent substrate;
- connecting functional films together via conductive means;
- connecting the first functional film to the junction box via conductive means.

One of the two busbars of the first functional film is connected to two conductive means and the other busbar is connected to a third conductive mean.

Preferably, functional films are applied on the transparent substrate with an interlayer. The interlayer can be a glue or any other material able to fix functional film on the transparent substrate such as PVB, EVA, ionomer, spalshield from Dupont, silicones (mastic and adhesive), MS-Polymer Polyurethanes and modified PU (e.g. SPUR), epoxy resins (2 components or UV), acrylic resins (2 components or UV), acrylic adhesive (« transfer tape »), Polyisobutylene, EVA resin and hot melt resin, cyanoacrylates, ...

According to the invention, conductive means are connected to functional films by soldering, gluing or any method able to electrically connect functional films and conductive means.

Conductive means are electrically connected to the junction box by well-known methods for example, plugged method, soldering, gluing,...

### Figures

The present invention will now be more particularly described with reference to drawings and exemplary embodiments, which are provided by way of illustration and not of limitation. The drawings are a schematic representation and not true to scale. The drawings do not restrict the invention in any way. More advantages will be explained with examples.
Fig. 1 is a plan view of one embodiment of an assembly according to the invention.
Fig. 2 is a plan view of a second embodiment of an assembly not part of the invention.

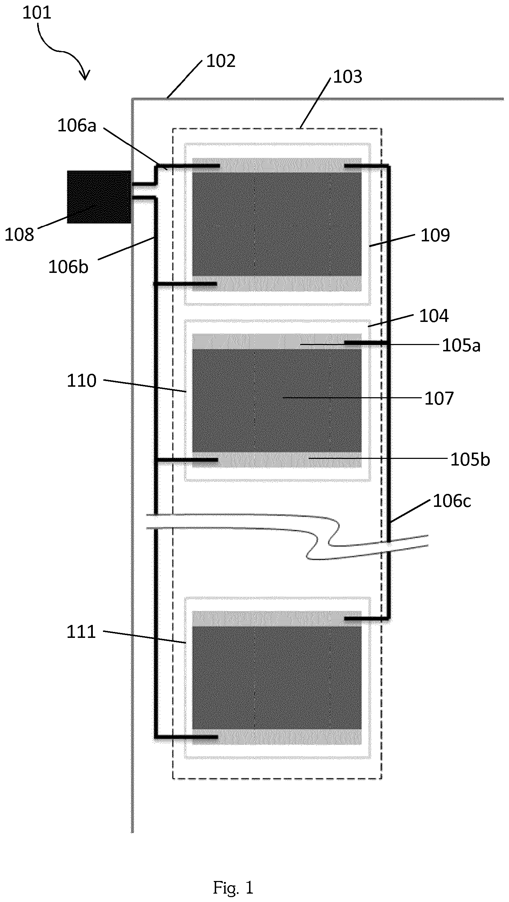

Referring to the Fig. 1 according to one embodiment of this invention, the assembly **101** comprises a transparent substrate **102**; a junction box **108**; at least one array **103,** arranged on the transparent substrate **102** and comprising a plurality of functional films **109, 110, 111** with a first **109** and a last functional film **111.** According to the invention, the assembly may comprises only functional film **109** and **111** but also additional functional films **110** which should be understood as one or a plurality of functional films. The first functional film **109** is placed at the nearest place from the junction box **108,** wherein each functional film is composed of an active element **107** and two busbars **105a, 105b.** The two busbars **105a, 105b** which electrically connect the active element **107** to the junction box **108,** are oppositely disposed along at least a part of the border of active element **107.** The functional films **109, 110, 111** are electrically connected in parallel starting from the first functional film **109.** Conductive means **106a, 106b, 106c** link the functional films **109, 110, 111** together and link directly the first functional film **109** to the junction box **108.** One of the two busbars**105a, 105b** of the first functional film is connected to two conductive means **106a, 106c** and the other busbar is connected to a third conductive mean **106b.**

In this particular embodiment, each functional film is placed in the assembly in the manner that busbars are in parallel. In that embodiment, functional films except the first functional film **109** are connected with two conductive means **106a, 106c;** the first functional film **109** with three **106a, 106b, 106c.**

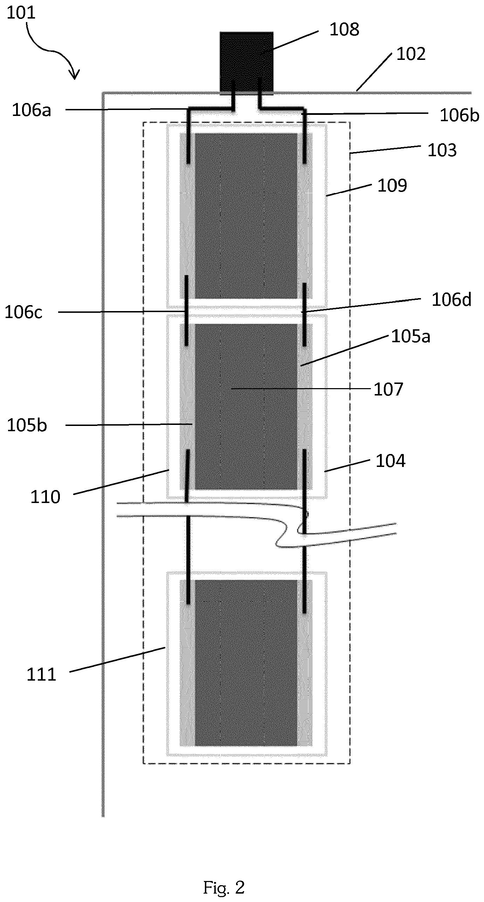

Referring to the Fig. 2 according to another embodiment not part of the present invention, the assembly **101** comprises a transparent substrate **102;** a junction box **108;** at least one array **103,** arranged on the transparent substrate **102,** comprising a plurality of functional films **109, 110, 111** with a first **109** and a last functional film **111,** the first functional film **109** being placed at the nearest place from the junction box **108,** wherein each functional film is composed of an active element **107** and two busbars **105a, 105b** which electrically connect the active element **107,** are oppositely and disposed along at least a part of the border of active element **107.** The functional films **109, 110, 111** are electrically connected in parallel starting from the first functional film **109.**

According to the invention, the assembly may comprises only functional film **109** and **111** but also additional functional films **110** which should be understood as one or a plurality of functional films.

According to this embodiment, conductive means **106a, 106b** link the first functional film **109** to the junction box **108.** Conductive means **106c, 106d** link functional films **109, 110, 111** together. One of the two busbars **105a, 105b** of the first functional film is connected to two conductive means **106a, 106c** and the other busbar is connected to a third conductive mean **106b** and a fourth conductive mean **106d.**

In this embodiment, each functional film **109, 110, 111** are placed in the assembly in the manner that busbars are aligned regarding each other. In that embodiment, functional films **109, 110** except the last functional film **111** of the array are connected with four conductive means **106a, 106b, 106c, 106d.** The last functional film **111** is connected with two conductive means **106c; 106d** because is only directly connected to one, the previous one functional film. The other functional films are directly connected to two other functional films (previous and next), thanks to four connective means **106c, 106d** since the first functional film **109** is is directly connected to a second functional film **110** thanks to conductive means **106a, 106b** to the junction box **108** and to the next functional film **110** thanks to conductive means **106c, 106d.**

Particularly, the assembly **101** may have as transparent substrate **102** a clear glass sheet with at least one array of functional films, for example OPV films. The array **103** is linked with one junction box **108** disposed at the border of the glass sheet **102** or fixed at on the other surface of the glass sheet **102.** The first functional film **109** is directly connected to the junction box **108** thanks to Cu-based conductive strips **106a, 106b** and electrically connected to other films **110** thanks to Cu-based conductive strips **106c, 106d**

As for example, a plurality of arrays of functional films, for example OPV films, may be disposed on transparent substrate **102** and each array **103** is linked with one different junction box **108.**

The assembly **101** according to the invention can be assembled with a panel.

A realization mode of the present invention is to integrate the assembly according to the invention into a laminated structure. Thus, this laminated structure comprises the assembly **101;** at least one interlayer and a panel. Potentially some compensation layers may be added around functional films to compensate their thicknesses regarding the interlayer and to avoid delamination and/or apparition of bubbles. The lamination interlayers are well known and could be, for example, a polyvinylbutyral (PVB), ethylene vinyl acetate (EVA), ionomer or polyurethane (PU). The junction box could **108** be placed on the rear side of the assembly **101** as well as on the edge.

The panel could be a glass sheet, a polycarbonate sheet or any other material able to be laminated.

To manufacture a laminated structure, one or more interlayers may be applied on the transparent substrate. The interlayer can be a glue or any other material able to fix functional film on the transparent substrate suchg as PVB, EVA, ionomer, spalshield from Dupont, silicones (mastic and adhesive), MS-Polymer Polyurethanes and modified PU (e.g. SPUR), epoxy resins (2 components or UV), acrylic resins (2 components or UV), acrylic adhesive (« transfer tape »), Polyisobutylene, EVA resin and hotmelt resin, cyanoacrylates, ...

The functional films are then added on the interlayer and the electric connections are put on. Optionally, a compensation layer of interlayer can be added on the surroundings of functional films to obtain a better aesthetical result and avoiding delamination (no bubbles, ...).

One or more layers of interlayer is (are) added on this stack. For example, the use of ethylene vinyl acetate copolymer (EVA) as thermoplastic interlayer layer allows to decrease the temperature used during the lamination process and allows to prevent the degradation of the films specially if functional films comprise functional PV organic molecules. In parallel, there is no need of high pressure during the lamination process (autoclave) thanks to the use of this kind of interlayer.

Then, a substrate is placed on top of this assembly. According to the present invention, the substrate may be any rigid structure, including plastic or glass or any other material able to be laminated. Preferably, the substrate is a glass substrate. The glass substrate used may be flat glass, in particular float glass of various thicknesses; it may be soda lime glass and may be clear, extra-clear, coloured, etched, sand-blasted, patterned or coated glass, or particular compositions for display applications. The glass may be bent. Glass sheets according to the invention may have a size greater than 1m x 1m. They may have various sizes depending on the desired application. This substrate may be a lacquered glass for an aesthetic aspect.

According to another embodiment of the present invention, the transparent substrate is a heat treated glass sheet, for example annealed or tempered and/or bended glass sheet. Typically, this involves heating the glass sheet (coated or not) in a furnace to a temperature of at least 580°C, more preferably of at least about 600°C and still more preferably of at least 620°C before rapidly cooling down the glass substrate. This tempering and/or bending can take place for a period of at least 4 minutes, at least 5 minutes, or more in different situations.

The glass may be coated with an anti-reflective coating or any coating able to improve the energy transmission of the glass, an anti-scratch coating, or any other coating known.

This assembly is tightly fixed and placed in a device able to apply low pressures and high temperatures, submitted to a degassing step under reduced pressures (typically below 0.35-0.15 bar) for at least 30 minutes, and then to temperatures of at least 95°C for at least 45 min.

The vacuum has been removed at the same high temperatures for more than 3 hours, then the temperature is reduced and the assembly is removed from the device.

A second realization mode of the present invention is to integrate the assembly according to the invention to an insulated glazing structure, for example a multiple glazing. This structure comprises the assembly and a glass sheet separated by a spacer. The spacer is glued to the assembly and to the glass sheet. The sealing of the insulating unit is done according to a common process for a double glazing. To prepare the assembly, the functional films can, for example, be glued with the following materials: PVB, EVA, ionomer, spalshield from Dupont, silicones (mastic and adhesive), MS-Polymer Polyurethanes and modified PU (e.g. SPUR), epoxy resins (2 components or UV), acrylic resins (2 components or UV), acrylic adhesive (« transfer tape »), Polyisobutylene, EVA resin and hotmelt resin, cyanoacrylates, ... The junction box could be placed on the rear side of the assembly as well as on the edge.

The glass sheet can be tempered to respect with the specifications of safety. The glass sheet can also be a laminated glass structure assembled in the multiple glazing.

## Claims

1. Assembly (101) comprising :
- a transparent substrate (102);
- a junction box (108);
- at least one array (103), arranged on the transparent substrate (102), comprising a plurality of functional films (109-111) with a first (109) and a last functional (111) film, the first functional (109) film being placed at the nearest place from the junction box (108), wherein each functional film (109-111) is composed of an active element (107) and two busbars (105a, 105b) which electrically connect the active element (107), the two busbars (105a, 105b) oppositely disposed along at least a part of the borders of the active element (107) and wherein the functional films (109-111) are electrically connected in parallel starting from the first functional film (109); said functional films being photovoltaic films;
- conductive means (106a, 106b, 106c) linking the functional films (109-111) together in parallel and linking directly the first functional film (109) to the junction box (108);
**characterized in that** one of the two busbars (105a) of the first functional film (109) is connected to two conductive means (106a, 106c) and the other busbar (105b) is connected to a third conductive mean (106b),
**in that** the plurality of functional films (109-111) comprises a further functional film (110),
**in that** one of the two busbars (105a) of the first functional film (109) is directly connected to the junction box (108) via one of the two conductive means (106a) and directly connected to the others functional films (110, 111) via the other conductive mean (106c) and the other busbar (10 5b) of the first functional film (109) is directly connected to the junction box (108) and to the others functional films (110, 111) via the third conductive mean (106b)
**and in that** the functional films are electrically connected in parallel starting from the first functional film.

2. Assembly (101) according to any preceding claims **characterized in that** the said transparent substrate is a glass sheet.

3. Assembly according to claim 2 **characterized in that** the said glass sheet has an energy transmission (ET), for a thickness of 3.85 mm, of at least 89%.

4. Assembly according to claim 1 or 2 **characterized in that** the glass sheet is made of a glass with low iron content.

5. Assembly according to any preceding claims **characterized in that** the said conductive means (106a, 106b, 106c) are conductive strips.

6. Assembly according to any preceding claims **characterized in that** said functional films (109-111) are organic photovoltaic films.

7. Process to manufacture an assembly (101) according to claim 1 comprising the following steps :
- applying the functional films (109-111) on the transparent substrate (102);
- connecting said functional films (109-111) together via conductive means (106a, 106b, 106c);
- connecting the first functional film (109) to the junction box (108) via conductive means (106a, 106b, 106c).

## Patentansprüche

1. Baugruppe (101), umfassend:
- ein transparentes Substrat (102);
- einen Verteilerkasten (108);
- mindestens eine Anordnung (103), die auf dem transparenten Substrat (102) angeordnet ist, die eine Mehrzahl von funktionalen Folien (109-111) mit einer ersten (109) und einer letzten funktionalen (111) Folie umfasst, wobei die erste funktionale (109) Folie an der nächstgelegenen Stelle zu dem Verteilerkasten (108) platziert ist, wobei jede funktionale Folie (109-111) aus einem aktiven Element (107) und zwei Sammelschienen (105a, 105b) besteht, die das aktive Element (107) elektrisch verbinden, wobei die zwei Sammelschienen (105a, 105b) entlang zumindest eines Teils der Grenzen des aktiven Elements (107) gegenüberliegend angeordnet sind und wobei die funktionalen Folien (109-111) ausgehend von der ersten funktionalen Folie (109) elektrisch parallel verbunden sind; wobei die funktionalen Folien Photovoltaik-Folien sind;
- leitfähige Mittel (106a, 106b, 106c), die die funktionalen Folien (109-111) parallel miteinander koppeln und die erste funktionale Folie (109) direkt mit dem Verteilerkasten (108) koppeln;
**dadurch gekennzeichnet, dass** eine der zwei Sammelschienen (105a) der ersten funktionalen Folie (109) mit zwei leitfähigen Mitteln (106a, 106c) verbunden ist und die andere Sammelschiene (105b) mit einem dritten leitfähigen Mittel (106b) verbunden ist,
**dadurch, dass** die Mehrzahl von funktionalen Folien (109-111) eine weitere funktionale Folie (110) umfasst,
**dadurch, dass** eine der zwei Sammelschienen (105a) der ersten funktionalen Folie (109) über eines der zwei leitfähigen Mittel (106a) direkt mit dem Verteilerkasten (108) verbunden ist und über das andere leitfähige Mittel (106c) direkt mit den anderen funktionalen Folien (110, 111) verbunden ist und die andere Sammelschiene (105b) der ersten funktionalen Folie (109) über das dritte leitfähige Mittel (106b) direkt mit dem Verteilerkasten (108) und mit den anderen funktionalen Folien (110, 111) verbunden ist
**und dadurch, dass** die funktionalen Folien ausgehend von der ersten funktionalen Folie elektrisch parallel verbunden sind.

2. Baugruppe (101) nach einem der vorhergehenden Ansprüche, **dadurch gekennzeichnet, dass** das transparente Substrat eine Glasscheibe ist.

3. Baugruppe nach Anspruch 2, **dadurch gekennzeichnet, dass** die Glasscheibe, bei einer Dicke von 3,85 mm, eine Energieübertragung (ET) von mindestens 89 % aufweist.

4. Baugruppe nach Anspruch 1 oder 2, **dadurch gekennzeichnet, dass** die Glasscheibe aus einem Glas mit niedrigem Eisengehalt besteht.

5. Baugruppe nach einem der vorhergehenden Ansprüche, **dadurch gekennzeichnet, dass** die leitfähigen Mittel (106a, 106b, 106c) leitfähige Streifen sind.

6. Baugruppe nach einem der vorhergehenden Ansprüche, **dadurch gekennzeichnet, dass** die funktionalen Folien (109-111) organische Photovoltaik-Folien sind.

7. Verfahren zum Herstellen einer Baugruppe (101) nach Anspruch 1, umfassend die folgenden Schritte:
- Aufbringen der funktionalen Folien (109-111) auf das transparente Substrat (102);
- Verbinden der funktionalen Folien (109-111) miteinander über leitfähige Mittel (106a, 106b, 106c);
- Verbinden der ersten funktionalen Folie (109) mit dem Verteilerkasten (108) über leitfähige Mittel (106a, 106b, 106c).

## Revendications

1. Ensemble (101) comprenant :
- un substrat transparent (102) ;
- une boîte de jonction (108) ;
- au moins une matrice (103), agencée sur le substrat transparent (102), comprenant une pluralité de films fonctionnels (109-111) avec un premier (109) et un dernier (111) film fonctionnel, le premier film fonctionnel (109) étant placé à l'endroit le plus proche de la boîte de jonction (108), chaque film fonctionnel (109-111) étant composé d'un élément actif (107) et de deux barres omnibus (105a, 105b) qui connectent électriquement l'élément actif (107), les deux barres omnibus (105a, 105b) étant disposées de façon opposée le long d'au moins une partie des bordures de l'élément actif (107) et les films fonctionnels (109-111) étant électriquement connectés en parallèle à partir du premier film fonctionnel (109) ; lesdits films fonctionnels étant des films photovoltaïques ;
- des moyens conducteurs (106a, 106b, 106c) reliant les films fonctionnels (109-111) ensemble en parallèle et reliant directement le premier film fonctionnel (109) à la boîte de jonction (108) ;
**caractérisé en ce que** l'une des deux barres omnibus (105a) du premier film fonctionnel (109) est connectée à deux moyens conducteurs (106a, 106c) et l'autre barre omnibus (105b) est connectée à un troisième moyen conducteur (106b),
**en ce que** la pluralité de films fonctionnels (109-111) comprend un film fonctionnel supplémentaire (110),
**en ce que** l'une des deux barres omnibus (105a) du premier film fonctionnel (109) est directement connectée à la boîte de jonction (108) par l'intermédiaire de l'un des deux moyens conducteurs (106a) et directement connectée aux autres films fonctionnels (110, 111) par l'intermédiaire de l'autre moyen conducteur (106c) et l'autre barre omnibus (105b) du premier film fonctionnel (109) est directement connectée à la boîte de jonction (108) et aux autres films fonctionnels (110, 111) par l'intermédiaire du troisième moyen conducteur (106b)
**et en ce que** les films fonctionnels sont électriquement connectés en parallèle à partir du premier film fonctionnel.

2. Ensemble (101) selon l'une quelconque des revendications précédentes **caractérisé en ce que** ledit substrat transparent est une feuille de verre.

3. Ensemble selon la revendication 2 **caractérisé en ce que** ladite feuille de verre a une transmission d'énergie (ET), pour une épaisseur de 3,85 mm, d'au moins 89 %.

4. Ensemble selon la revendication 1 ou la revendication 2 **caractérisé en ce que** la feuille de verre est en verre à faible teneur en fer.

5. Ensemble selon l'une quelconque des revendications précédentes **caractérisé en ce que** lesdits moyens conducteurs (106a, 106b, 106c) sont des bandes conductrices.

6. Ensemble selon l'une quelconque des revendications précédentes **caractérisé en ce que** lesdits films fonctionnels (109-111) sont des films photovoltaïques organiques.

7. Procédé de fabrication d'un ensemble (101) selon la revendication 1 comprenant les étapes suivantes :
- appliquer les films fonctionnels (109-111) sur le substrat transparent (102) ;
- connecter lesdits films fonctionnels (109-111) ensemble par l'intermédiaire de moyens conducteurs (106a, 106b, 106c) ;
- connecter le premier film fonctionnel (109) à la boîte de jonction (108) par l'intermédiaire de moyens conducteurs (106a, 106b, 106c).
